# EUROPEAN PATENT APPLICATION

(11) **EP 2 339 655 A2**
(43) Date of publication of application: **29.06.2011**
(21) Application number: 10196526.7
(22) Date of filing: 22.12.2010
(51) Int. Cl.: H01L 33/44, H01L 33/50, H01L 33/46

(54) **Multi-stack package led**

(30) Priority: 25.12.2009 TW 098145139; 29.03.2010 TW 099109463
(71) Applicant: Industrial Technology Research Institute, Chu-Tung, Hsinchu (TW)
(72) Inventor: Cheng, Chia-Shen, Taichung City (TW); Lin, Jian-Shian, Yilan City (TW); Chen, Shau-Yi, Xiluo Township (TW); Lin, Hsiu-Jen, Zhubei City (TW); Peng, Yao-Chi, Hsinchu City (TW)
(74) Representative: Viering, Jentschura & Partner

(57) **Abstract**

A multi-stack package light emitting diode (LED) includes an LED chip, a first fluorescent powder layer, a first optical bandpass filter layer and a second fluorescent powder layer. The LED chip generates an LED light. The first fluorescent powder layer and the second fluorescent powder layer respectively have a first fluorescent powder and a second fluorescent powder. The first fluorescent powder and the second fluorescent powder are excited by the LED light to respectively generate a first excitation light and a second excitation light. The first optical bandpass filter layer allows the LED light and the first excitation light to pass and reflects the second excitation light. A wavelength of the LED light is shorter than a wavelength of the second excitation light. The wavelength of the second excitation light is shorter than a wavelength of the first excitation light. Therefore, the multi-stack package LED improves a light emission efficiency.

## Description

### BACKGROUND

### Field

The present disclosure relates to a light emitting diode (LED), and more particularly to a multi-stack package LED.

### Related Art

With the improvement of the light emission efficiency of a white LED, the white LED has become a new-generation light source attracting more attentions. At present, the light emission efficiency of the white LED ranges from an experimental-scale 249 lm/W (Lumen Per Watt) to the commercial-scale 100 lm/W. The light emission efficiency is still under improvement.

Although the light emission efficiency of the white LED has been improved, in order to make the color rendering property (or called as color rendering index) achieve the industrial application level, the light emission efficiency must be sacrificed. At present, regarding the white LED having the color rendering property of 90%, the light emission efficiency is only about 60 lm/W.

R.O.C. (Taiwan) Patent Publication No. I276238 relates to the white LED. The patent discloses a white LED element for emitting a white light, which includes an LED chip for emitting an excitation light, a first fluorescent powder and a second fluorescent powder. The first fluorescent powder and the second fluorescent powder respectively absorb the first excitation light and the second excitation light in the excitation light emitted by the LED chip, and accordingly excite a first emitted light and a second emitted light. The excitation light emitted by the LED chip, the first emitted light excited by the first fluorescent powder and the second emitted light excited by the second fluorescent powder are mixed to form the white light.

R.O.C. (Taiwan) Patent Publication No. I296696 relates to a planar light-emitting source with adjustable color temperature and high color rendering property, which mainly forms a light-transmissive area and a coating area on a surface of a photoluminescent primary light source capable of exciting a fluorescent powder and coats fluorescent powder blocks that could be excited to emit different colors on the coating area. The light source transmitting the light-transmissive area is mixed with the lights having different wavelengths emitted by the fluorescent powder blocks to generate the white light, and meanwhile the shape and size of the fluorescent powder blocks may be used to adjust the saturation and color temperature of the white light, so that the light source achieves high color rendering property.

R.O.C. (Taiwan) Patent Publication No. I297383 relates to a method of photo-exciting a fluorescent sheet to achieve better color rendering property, which mainly uses a ultra violet (UV) light to irradiate on a fluorescent sheet formed by a stack of red, green, and blue sheets sequentially, so the color rendering property is better and reaches 90%, which is approximate to the sunlight, and the fluorescent sheet may also be directly coated with three layers of color fluorescent powders or directly coated with a mixture of three colors.

According to the above patents, an LED light is used to excite different fluorescent powders and then the lights are blended to generate the white light. Although this technology may generate the white light, the excitation effect of the fluorescent powder is not good and the light emission efficiency is a half of an ordinary white LED.

### SUMMARY

In view of the above problems, the present disclosure provides a multi-stack package LED, which can eliminate the phenomena of secondary excitation between different kinds of fluorescent powders, thereby avoiding the loss of the light emission efficiency caused by the secondary excitation and reducing the loss in absorption and conversion.

According to an embodiment, the multi-stack package LED comprises an LED chip, a first fluorescent powder layer, a first optical bandpass filter layer and a second fluorescent powder layer. The LED chip generates LED light when being driven. The first fluorescent powder layer is disposed on the LED chip and has multiple first fluorescent powders. The first fluorescent powders are excited by the LED light to generate first excitation light. The first optical bandpass filter layer is disposed on the first fluorescent powder layer and allows the LED light and the first excitation light to pass. The second fluorescent powder layer is disposed on the first optical bandpass filter layer and has multiple second fluorescent powders. The second fluorescent powders are excited by the LED light to generate second excitation light. A wavelength of the second excitation light is shorter than a wavelength of the first excitation light.

According to an embodiment, the first optical bandpass filter layer reflects the second excitation light. A wavelength of the LED light is shorter than a wavelength of the second excitation light.

According to an embodiment, a central wavelength of the LED light may be between 430 nm and 500 nm. A central wavelength of the first excitation light may be between 610 nm and 780 nm. A central wavelength of the second excitation light may be between 540 nm and 560 nm.

According to another embodiment, the multi-stack package LED further comprises a second optical bandpass filter layer and a third fluorescent powder layer. The second optical bandpass filter layer is disposed on the second fluorescent powder layer and allows the LED light, the first excitation light and the second excitation light to pass. The third fluorescent powder layer is disposed on the second optical bandpass filter layer and has multiple third fluorescent powders. The third fluorescent powders are excited by the LED light to generate third excitation light. A wavelength of the third excitation light is shorter than the wavelength of the second excitation light.

According to another embodiment, the second optical bandpass filter layer reflects the third excitation light.

According to another embodiment, a central wavelength of the LED light may be between 430 nm and 500 nm. A central wavelength of the first excitation light may be between 610 nm and 780 nm. A central wavelength of the second excitation light may be between 555 nm and 580 nm. A central wavelength of the third excitation light may be between 540 nm and 555 nm.

The first fluorescent powder layer, the second fluorescent powder layer and the third fluorescent powder layer respectively have a thickness between 100 µm and 300 µm.

According to yet another embodiment of the present disclosure, the multi-stack package LED comprises an LED chip, a first fluorescent powder layer and a second fluorescent powder layer. The LED generates an LED light when being driven. The first fluorescent powder layer is disposed on the LED chip and has multiple first fluorescent powders. The first fluorescent powders are excited by the LED light to generate first excitation light. The second fluorescent powder layer is disposed on the first fluorescent powder layer and has multiple second fluorescent powders. The second fluorescent powders are excited by the LED light to generate second excitation light. A wavelength of the LED light is shorter than a wavelength of the second excitation light. The wavelength of the second excitation light is shorter than a wavelength of the first excitation light.

According to another embodiment, a refraction index of the second fluorescent powder layer is higher than a refraction index of the first fluorescent powder layer.

The wavelengths of the fluorescent powder layers are designed according to the stack relations, and the optical bandpass filter layers filter and reflect the wavelengths, so that the excitation light generated after the fluorescent powder layers are excited will not be absorbed by other fluorescent powder layers, thereby eliminating the loss of the secondary excitation and achieve a better light emission efficiency. Then, after appropriately adjusting the wavelengths of the excitation lights of all fluorescent powder layers and the wavelength of the LED light emitted by the LED, a mixed light having high color rendering property is obtained.

### BRIEF DESCRIPTION OF THE DRAWINGS

The present disclosure will become more fully understood from the detailed description given herein below for illustration only, and thus are not limitative of the present disclosure, and wherein:
FIG. 1 is a schematic sectional view of a multi-stack package LED according to a first embodiment of the present disclosure;
FIG. 2A and FIG. 2B are schematic structural views of a multi-stack package LED according to the first embodiment of the present disclosure and a control group;
FIG. 2C is a spectrogram of FIG. 2A and FIG. 2B;
FIG. 3 is a schematic sectional view of a multi-stack package LED according to a second embodiment of the present disclosure;
FIG. 4 is a schematic sectional view of a multi-stack package LED according to a third embodiment of the present disclosure;
FIG. 5 is a schematic sectional view of a multi-stack package LED according to a fourth embodiment of the present disclosure;
FIG. 6 is a schematic sectional view of a multi-stack package LED according to a fifth embodiment of the present disclosure;
FIG. 7 is a schematic sectional view of a multi-stack package LED according to a sixth embodiment of the present disclosure;
FIG. 8 is a schematic sectional view of a multi-stack package LED according to a seventh embodiment of the present disclosure;
FIG. 9 is a partially enlarged schematic sectional view of the seventh embodiment of the present disclosure; and
FIG. 10 is a top view of FIG. 9.

### DETAILED DESCRIPTION

### THE FIRST EMBODIMENT

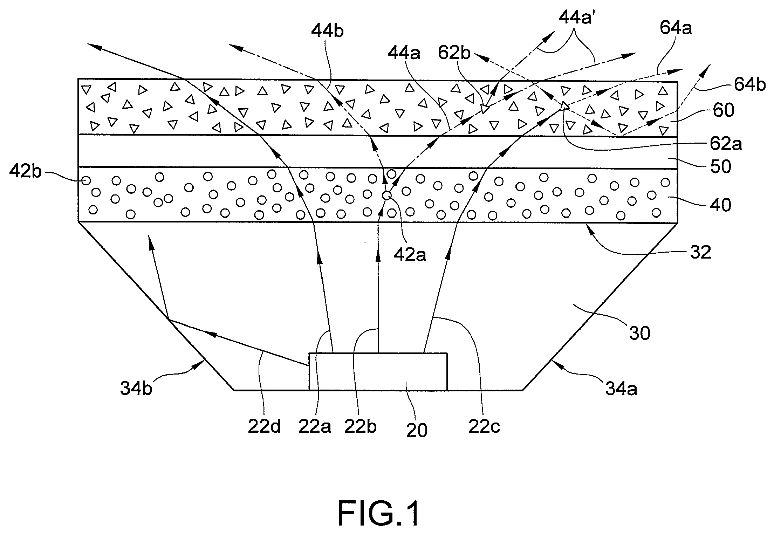

Firstly, FIG. 1 is a schematic sectional view of a multi-stack package LED according to the present disclosure. Referring to FIG. 1, the multi-stack package LED comprises an LED chip 20, a package 30, a first fluorescent powder layer 40, a first optical bandpass filter layer 50 and a second fluorescent powder layer 60.

The LED chip 20 generates LED lights 22a, 22b, 22c, 22d when being driven (indicated by thin solid lines in the figure). The LED lights 22a, 22b, 22c, 22d generated by the LED chip 20 may be UV lights, blue lights or green lights. The wavelengths of the LED lights 22a, 22b, 22c, 22d may fit the corresponding wavelengths of the first fluorescent powder layer 40, the first optical bandpass filter layer 50 and the second fluorescent powder layer 60 and are mixed, and the mixed light may be, but is not limited to, a white light.

The package 30 is covered on the LED chip 20. A surface of the package 30 opposite to the LED chip 20 is a light exiting surface 32. Furthermore, the package 30 has slanted side edges 34a, 34b. The slanted side edges 34a, 34b surround sides of the package 30 to reflect the LED light 22d from the LED chip 20 to the light exiting surface 32. A refraction index of the package 30 may be designed to be greater than a refraction index of a medium contiguous to the slanted side edges 34a, 34b. In this way, the LED light 22d emitted by the LED chip 20 has total reflection between the package 30 and the medium within a specific incident angle. Therefore, more LED lights 22a, 22b, 22c, 22d will travel towards the light exiting surface 32. In addition, the slanted side edges 34a, 34b may also be covered by a reflective layer or a reflecting medium, for example, a metal layer.

The first fluorescent powder layer 40 is disposed on the light exiting surface 32 and has multiple first fluorescent powders 42a, 42b. In other words, the package 30 is clamped between the LED chip 20 and the first fluorescent powder layer 40. The first fluorescent powders 42a, 42b are excited by the LED light 22b to generate first excitation lights 44a, 44b (indicated by thin dash-and-dot lines in the figure). As shown in the figure, a part of the LED lights 22a, 22c directly passes through the first fluorescent powder layer 40 without exciting the first fluorescent powders 42a, 42b.

The first optical bandpass filter layer 50 is disposed on the first fluorescent powder layer 40 and allows the LED lights 22a, 22b, 22c, 22d and the first excitation lights 44a, 44b to pass. The first optical bandpass filter layer 50 may allow the lights including but not limited to the lights corresponding to the spectrum of the LED lights 22a, 22b, 22c, 22d and the first excitation lights 44a, 44b to pass, and reflects lights of the rest spectrum.

The second fluorescent powder layer 60 is disposed on the first optical bandpass filter layer 50 and has multiple second fluorescent powders 62a, 62b. The second fluorescent powders 62a, 62b are excited by the LED lights 22a, 22b, 22c, 22d to generate second excitation lights 64a, 64b (indicated by thin dashed lines in the figure). The first optical bandpass filter layer 50 reflects the second excitation lights 64a, 64b.

Generally speaking, the fluorescent powders in the fluorescent powder layer may absorb the light having a short wavelength, and are excited to generate a light having a long wavelength. Therefore, the wavelengths of the LED lights 22a, 22b, 22c, 22d are shorter than the wavelengths of the second excitation lights 64a, 64b, and the wavelengths of the second excitation lights 64a, 64b are shorter than the wavelengths of the first excitation lights 44a, 44b. That is to say, the wavelengths of the LED lights 22a, 22b, 22c, 22d are the shortest.

The central wavelengths of the LED lights 22a, 22b, 22c, 22d may be between 430 nm and 500 nm, for example, the LED lights 22a, 22b, 22c, 22d are blue lights of 465 nm. The central wavelengths of the first excitation lights 44a, 44b may be between 610 nm and 780 nm, for example, the first excitation lights 44a, 44b are red lights of 650 nm, so the red first fluorescent powders 42a, 42b may be selected. The central wavelengths of the second excitation lights 64a, 64b may be between 540 nm and 560 nm, for example, the second excitation lights 64a, 64b are green lights of 550 nm, so the green second fluorescent powders 62a, 62b may be selected.

From the above illustration, it is known that, the LED lights 22a, 22b, 22c, 22d generated by the LED chip 20 are emitted towards the light exiting surface 32. The LED light 22a does not contact the first fluorescent powders 42a, 42b and the second fluorescent powders 62a, 62b, but is emitted directly from the second fluorescent powder layer 60.

The LED light 22b contacts the first fluorescent powder 42a, and excites the first fluorescent powder 42a to generate the first excitation lights 44a, 44b. The first excitation light 44b passes through the first optical bandpass filter layer 50 and the second fluorescent powder layer 60 sequentially, and does not contact second fluorescent powders 62a, 62b. After passing through first optical bandpass filter layer 50, the first excitation light 44a contacts the second fluorescent powder 62b at the second fluorescent powder layer 60. Since the wavelengths of the first excitation lights 44a, 44b are longer than the wavelengths of the second excitation lights 64a, 64b generated after the second fluorescent powders 62a, 62b are excited. Therefore, the first excitation light 44a is scattered to become 44a' (first excitation light) due to the second fluorescent powder 62b. The wavelength of the first excitation light 44a is not influenced by the second fluorescent powder 62b and remains unchanged, and the second fluorescent powder 62b is not excited to generate the second excitation lights 64a, 64b.

The LED light 22c passes through the first fluorescent powder layer 40 and the first optical bandpass filter layer 50. The LED light 22c contacts the second fluorescent powder 62a at the second fluorescent powder layer 60. Since the wavelength of the LED light 22c is shorter than the wavelengths of the second excitation lights 64a, 64b that can be generated after the second fluorescent powder 62a are excited, the LED light 22c excites the second fluorescent powder 62a to generate the second excitation lights 64a, 64b. The second excitation light 64a directly passes through the second fluorescent powder layer 60. The second excitation light 64b is reflected by the first optical bandpass filter layer 50 and then passes through the second fluorescent powder layer 60.

From the above description, it is known that the characteristic that the first optical bandpass filter layer 50 allows the LED lights 22a, 22b, 22c, 22d and the first excitation lights 44a, 44b to pass and reflects the second excitation lights 64a, 64b may avoid the second excitation lights 64a, 64b returning to the first fluorescent powder layer 40 to cause the secondary excitation. Then, the excitation lights may pass through the second fluorescent powder layer 60 in a short path to increase the light output efficiency. Furthermore, the wavelengths of the LED lights 22a, 22b, 22c, 22d are smaller than wavelengths of the second excitation lights 64a, 64b generated after the second fluorescent powders 62a, 62b in the second fluorescent powder layer 60 are excited, and the wavelengths of the second excitation lights 64a, 64b are smaller than the wavelengths of the first excitation lights 44a, 44b generated after the first fluorescent powders 42a, 42b in first fluorescent powder layer 40 are excited, so that the excited first excitation lights 44a, 44b do not have the secondary excitation when contacting the second fluorescent powders 62a, 62b. This design may also improve the light output efficiency.

Therefore, the lights passing through the second fluorescent powder layer 60 comprise LED lights 22a, 22b, 22c, 22d, the first excitation lights 44a, 44a', 44b and the second excitation lights 64a, 64b. According to the wavelengths of the LED lights 22a, 22b, 22c, 22d, the first excitation lights 44a, 44b and the second excitation lights 64a, 64b, are sequentially selected to blue lights, red lights and green lights. Therefore, a white light is obtained after the lights passing through the second fluorescent powder layer 60 are mixed.

According to the structure of the first embodiment, the thickness of the first fluorescent powder layer 40 and the second fluorescent powder layer 60 and the number of the first fluorescent powders 42a, 42b and the second fluorescent powders 62a, 62b may be appropriately adjusted to adjust the spectrum of the mixed light. The thickness of the first fluorescent powder layer 40 and the second fluorescent powder layer 60 may be between 100 µm and 300 µm.

The LED chip 20 covered by the package 30 is one LED chip 20 as shown in FIG. 1, but the number of the LED chip 20 is not thus limited. Multiple LED chips 20 may also be disposed in the package 30.

In this embodiment, the multi-stack package LED comprises the package 30, but the present disclosure is not thus limited. The multi-stack package LED may also does not comprise the package 30. That is to say, the first fluorescent powder layer 40 may be directly disposed on the LED chip 20. In this way, the LED light 22d directly enters the first fluorescent powder layer 40, thereby reducing the light loss of the LED light 22d passing through the package 30.

### THE EXPERIMENTAL VERIFICATION OF THE FIRST EMBODIMENT

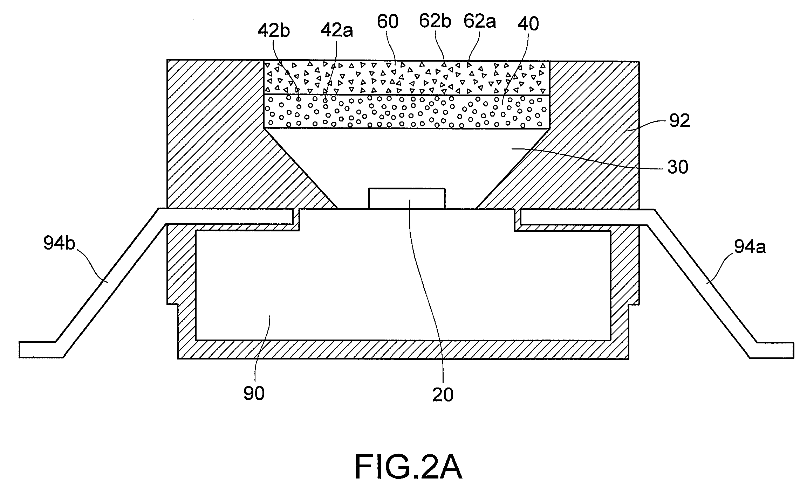

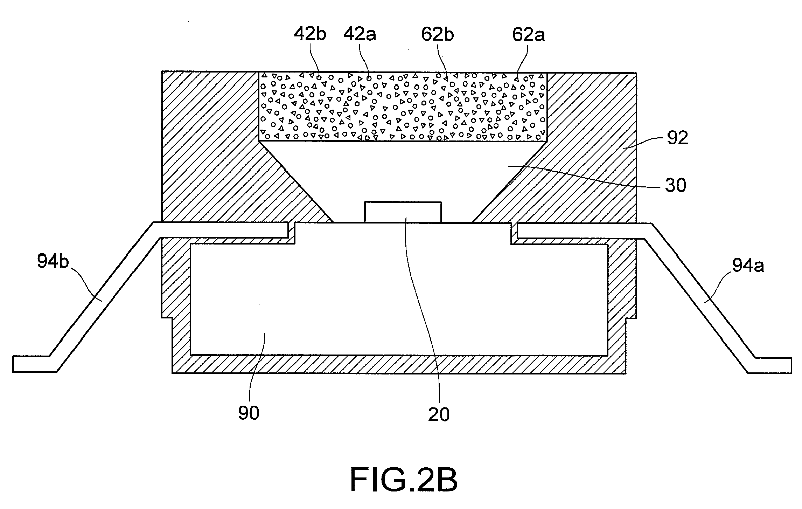

The experimental verification of the control group of the multi-stack package LED corresponding to the first embodiment is as shown in FIG. 2A and FIG. 2B, which are schematic structural views of the multi-stack package LED according to the first embodiment and the control group.

Referring to FIG. 2A, the multi-stack package LED is disposed on a substrate 90. The substrate 90 is covered by a packaging material 92, and only a central portion of the packaging material 92 has a bowl-shaped accommodation room. The multi-stack package LED is disposed in the accommodation room. The packaging material 92 may be, but is not limited to, a high molecular polymer and a plastic. The substrate 90 has leads 94a, 94b disposed on two sides thereof, for electrically connecting the LED chip 20. Through the leads 94a, 94b, a current or a Pulse Width Modulation (PWM) signal may be applied on the LED chip 20 from outside to make the LED chip 20 emit light.

The multi-stack package LED of FIG. 2A comprises an LED chip 20, a first fluorescent powder layer 40 and a second fluorescent powder layer 60. The first fluorescent powder layer 40 has multiple first fluorescent powders 42a, 42b. The second fluorescent powder layer 60 has multiple second fluorescent powders 62a, 62b. The multi-stack package LED of FIG. 2A differs from the multi-stack package LED of FIG. 1 in that the multi-stack package LED of FIG. 2A does not comprise the first optical bandpass filter layer 50. The multi-stack package LED of FIG. 2A achieves the function similar to the first optical bandpass filter layer 50 through the principle of total reflection. That is to say, a refraction index of the first fluorescent powder layer 40 of FIG. 2A is smaller than a refraction index of the second fluorescent powder layer 60. Therefore, when the light travels from the second fluorescent powder layer 60 to the first fluorescent powder layer 40, if the incident angle of the light is within the total reflection angle, the light is reflected and will not penetrate.

In FIG. 2A, the refraction index of the second fluorescent powder layer 60 is 1.76 and the refraction index of the first fluorescent powder layer 40 is 1.46. According to the law of refraction, the critical angle is about 56°. The first fluorescent powders 42a, 42b of FIG. 2A are red fluorescent powders. The second fluorescent powders 62a, 62b of FIG. 2A are green fluorescent powders. The LED light emitted by the LED chip 20 is a blue light.

The structure and material of the control group in FIG. 2B are similar to those of FIG. 2A except that in FIG. 2B, the first fluorescent powders 42a, 42b and the second fluorescent powders 62a, 62b are mixed in a single fluorescent powder layer.

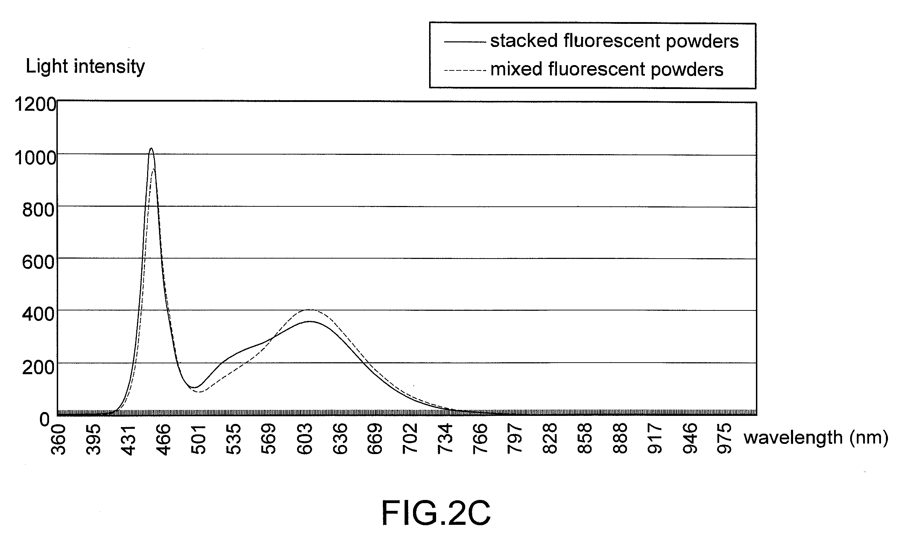

Then, referring to FIG. 2C, FIG. 2C is a compared spectrogram of the experimental verifications of FIG. 2A and FIG. 2B. The horizontal axis in this spectrogram is the wavelength in a unit of nm, and the vertical axis is the light intensity in a unit of µW. The curve indicated by the solid line in the figure is the spectrum of FIG. 2A. The curve indicated by the dashed line in the figure is the spectrum of FIG. 2B. As shown in FIG. 2C, the light intensity indicated by the solid line from 430 nm and 570 nm is greater than the light intensity indicated by the dashed line. This part demonstrates the improvement of the light emission efficiency owing to the total reflection design of FIG. 2A. That is to say, in the embodiment of FIG. 2A, regarding the green light (second excitation light) generated after the second fluorescent powders 62a, 62b are excited, only a small part of the green light penetrates and returns to the first fluorescent powder layer 40 and most of the green light passes through the second fluorescent powder layer 60 due to the limitation of the total reflection.

Further, based on the above total reflection effect, to further improve the luminous efficacy of the multi-stack package LED of the first embodiment, the refraction index of the first fluorescent powder layer 40 may be designed to be greater than the refraction index of the package 30. In this way, more first excitation lights 44a, 44b will travel towards the first optical bandpass filter layer 50.

### THE SECOND EMBODIMENT

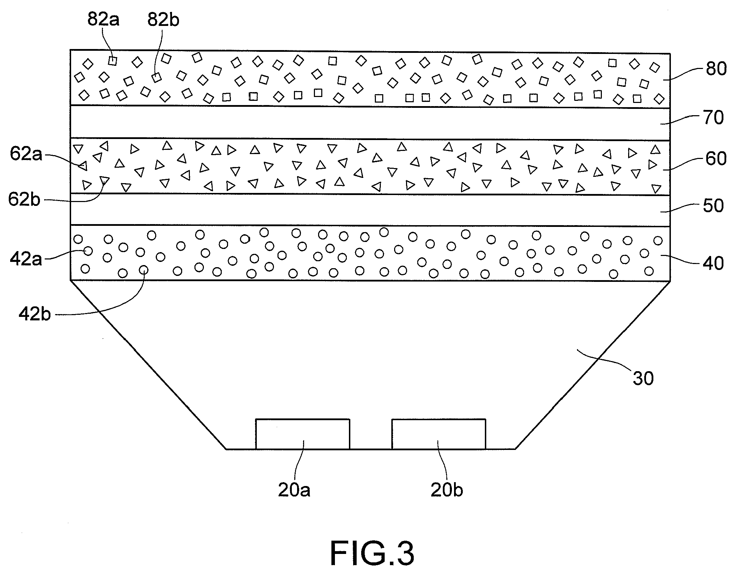

Then, FIG. 3 is a schematic sectional view of a multi-stack package LED according to the second embodiment of the present disclosure. Referring to FIG. 3, the multi-stack package LED comprises multiple LED chips 20a, 20b, a package 30, a first fluorescent powder layer 40, a first optical bandpass filter layer 50, a second fluorescent powder layer 60, a second optical bandpass filter layer 70 and a third fluorescent powder layer 80.

The light LED chips 20a, 20b generate the LED light when being driven (the reference numerals of the LED light, the first excitation light and the second excitation light are the same as those of FIG. 1, to simplify the drawings and the description, the reference numerals thereof are omitted in the second embodiment and the third embodiment and the following descriptions). The number of the LED chips 20a, 20b is, but not limited to, two in this embodiment, and one or more than two LED chips may be disposed.

The package 30 is covered on the LED chips 20a, 20b. The first fluorescent powder layer 40, the first optical bandpass filter layer 50, the second fluorescent powder layer 60, the second optical bandpass filter layer 70 and the third fluorescent powder layer 80 are sequentially stacked on the package 30.

The first fluorescent powder layer 40 has multiple first fluorescent powders 42a, 42b. The second fluorescent powder layer 60 has multiple second fluorescent powders 62a, 62b. The third fluorescent powder layer 80 has multiple third fluorescent powders 82a, 82b. When the first fluorescent powders 42a, 42b are excited, the first excitation light is generated. When the second fluorescent powders 62a, 62b are excited, the second excitation light is generated. When the third fluorescent powders 82a, 82b are excited, the third excitation light is generated. The thickness of the first fluorescent powder layer 40, the second fluorescent powder layer 60 and the third fluorescent powder layer 80 may be between 100 µm and 300 µm.

The first optical bandpass filter layer 50 allows the LED light and the first excitation light to pass and reflects the second excitation light. The second optical bandpass filter layer 70 allows the LED light, the first excitation light and the second excitation light to pass and reflects the third excitation light. In this way, the second excitation light is prevented to be incident on the first fluorescent powder layer 40 to generate the secondary excitation. Also, the third excitation light is prevented to be incident on the second fluorescent powder layer 60 or the first fluorescent powder layer 40 to generate secondary excitation.

Definitely, the first optical bandpass filter layer 50 may also reflect the third excitation light, but since the second optical bandpass filter layer 70 is disposed in the second embodiment, only a small part of the third excitation light passes through the second fluorescent powder layer 60 to reach the first optical bandpass filter layer 50. A wavelength of the LED light is shorter than a wavelength of the third excitation light. A wavelength of the third excitation light is shorter than a wavelength of the second excitation light. A wavelength of the second excitation light is shorter than a wavelength of the first excitation light. That is to say, the wavelength of the LED light is the shortest and the wavelength of the first excitation light is the longest.

To obtain the mixed white light, the central wavelength of the LED light may be between 430 nm and 500 nm, for example, the LED light is a blue light of 465 nm. The central wavelength of the first excitation light may be between 610 nm and 780 nm, for example, the first excitation light is a red light of 650 nm. The central wavelength of the second excitation light may be between 555 nm and 580 nm, for example, the second excitation light is a yellow light of 560 nm. The central wavelength of the third excitation light may be between 540 nm and 555 nm, for example, the third excitation light is a green light of 550 nm.

Furthermore, the wavelengths of all the elements may be adjusted. For example, the central wavelength of the LED light may be between 320 nm and 380 nm, for example, the LED light is a UV light of 365 nm. The central wavelength of the first excitation light may be between 610 nm and 780 nm, for example, the first excitation light is a red light of 650 nm. The central wavelength of the second excitation light may be between 530 nm and 560 nm, for example, the second excitation light is a green light of 550 nm. The central wavelength of the third excitation light may be between 380 nm and 500 nm, for example, the third excitation light is a blue light of 465 nm. However, the present disclosure is not thus limited.

### THE THIRD EMBODIMENT

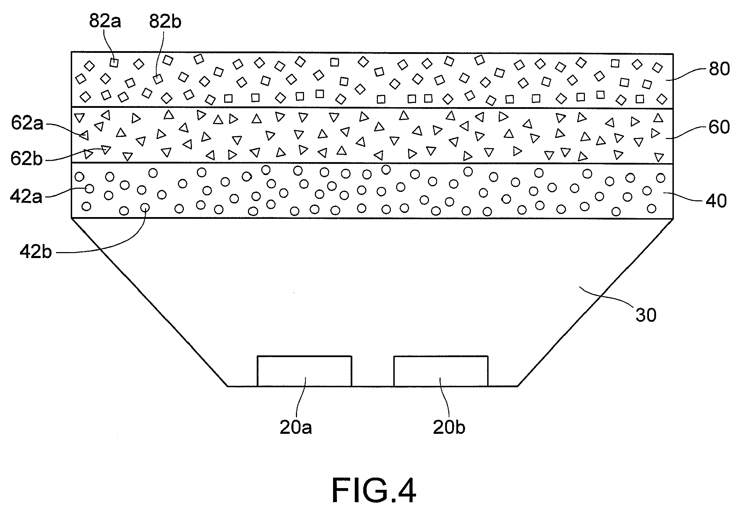

FIG. 4 is a schematic sectional view of a multi-stack package LED according to a third embodiment of the present disclosure. Referring to FIG. 4, the multi-stack package LED comprises LED chips 20a, 20b, a package 30, a first fluorescent powder layer 40, a second fluorescent powder layer 60 and a third fluorescent powder layer 80.

The first fluorescent powder layer 40 has multiple first fluorescent powders 42a, 42b. The second fluorescent powder layer 60 has multiple second fluorescent powders 62a, 62b. The third fluorescent powder layer 80 has multiple third fluorescent powders 82a, 82b. When the first fluorescent powders 42a, 42b are excited, the first excitation light is generated. When the second fluorescent powders 62a, 62b are excited, the second excitation light is generated. When the third fluorescent powders 82a, 82b are excited, the third excitation light is generated.

The refraction index of the third fluorescent powder layer 80 is higher than the refraction index of the second fluorescent powder layer 60. The refraction index of the second fluorescent powder layer 60 is higher than the refraction index of the first fluorescent powder layer 40. In this way, more third excitation light is reflected by the interface of the second fluorescent powder layer 60 and the third fluorescent powder layer 80. More second excitation light is reflected by the interface of the second fluorescent powder layer 60 and the first fluorescent powder layer 40. The configuration of the refraction indexes may increase the light output efficiency.

### THE FOURTH EMBODIMENT

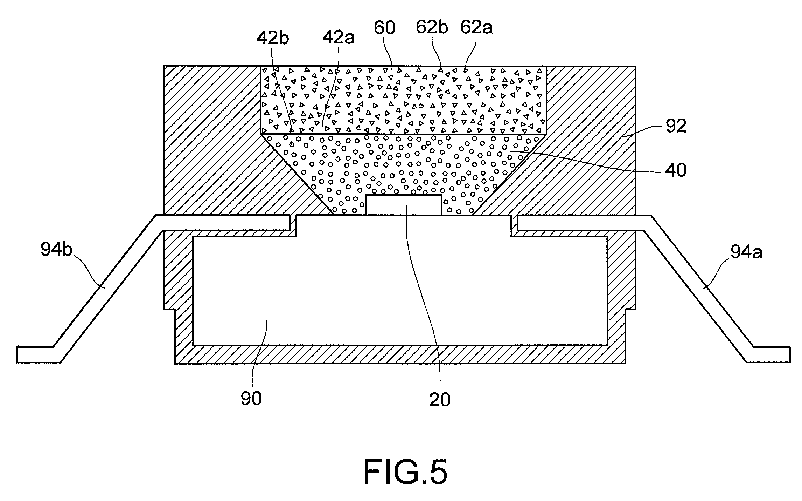

FIG. 5 is a schematic sectional view of a multi-stack package LED according to the fourth embodiment of the present disclosure. Referring to FIG. 5, the multi-stack package LED is disposed in a reflector cup formed by a substrate 90 and a packaging material 92. The multi-stack package LED comprises an LED chip 20, a first fluorescent powder layer 40 and a second fluorescent powder layer 60. The first fluorescent powder layer 40 is disposed on the LED chip 20. The second fluorescent powder layer 60 is disposed on the first fluorescent powder layer 40.

The first fluorescent powder layer 40 has multiple first fluorescent powders 42a, 42b. The second fluorescent powder layer 60 has multiple second fluorescent powders 62a, 62b. When the first fluorescent powders 42a, 42b are excited, the first excitation light is generated. When the second fluorescent powders 62a, 62b are excited, the second excitation light is generated.

The refraction index of the second fluorescent powder layer 60 is higher than the refraction index of the first fluorescent powder layer 40. Therefore, when the light travels from the second fluorescent powder layer 60 to the first fluorescent powder layer 40, if the incident angle of the light incident on the interface of the first and the second fluorescent powder layers 40, 60 is within the total reflection angle, the incident light is refracted and will not enter the first fluorescent powder layer 40 again, and also the secondary excitation phenomena will not occur. That is to say, the configuration of the refraction indexes may increase the light output efficiency. The ratio of the refraction index of the first fluorescent powder layer 40 to that of the second fluorescent powder layer 60 is, for example, 1:1.2(the refraction index of the first fluorescent powder layer 40: the refraction index of the second fluorescent powder layer 60). Then, as compared with the first, second, and third embodiments, the light emitted by the LED chip 20 of the fourth embodiment may directly enters the first fluorescent powder layer 40. In this way, the loss of the light passing through the package 30 is reduced.

The thickness of the first fluorescent powder layer 40 and the second fluorescent powder layer 60 may be, but is not limited to, 100 µm to 500 µm, for example, between 100 µm and 300 µm.

### THE FIFTH EMBODIMENT

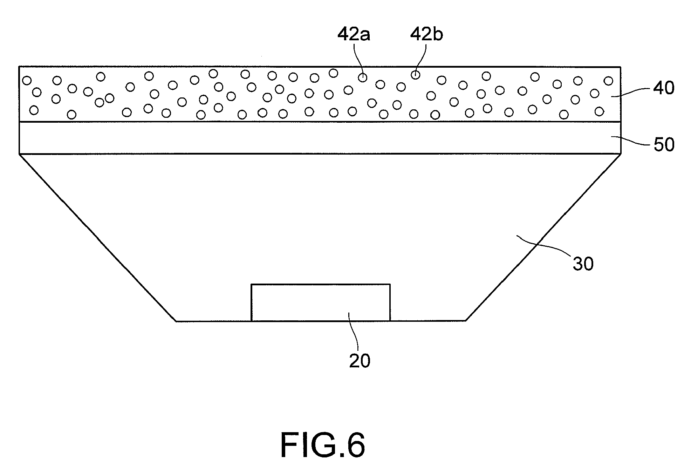

FIG. 6 is a schematic sectional view of a multi-stack package LED according to a fifth embodiment of the present disclosure. Referring to FIG. 6, the multi-stack package LED comprises an LED chip 20, a package 30, a first optical bandpass filter layer 50 and a first fluorescent powder layer 40.

The package 30 is covered on the LED chip 20. The first optical bandpass filter layer 50 and the first fluorescent powder layer 40 are sequentially stacked on the package 30. In specific, the first optical bandpass filter layer 50 is disposed on the LED chip 20 and the first fluorescent powder layer 40 is disposed on the first optical bandpass filter layer 50.

The first fluorescent powder layer 40 has multiple first fluorescent powders 42a, 42b. When the first fluorescent powders 42a, 42b are excited, the first excitation light is generated. The thickness of the first fluorescent powder layer 40 may be between 100 µm and 300 µm.

The first optical bandpass filter layer 50 allows the LED light coming from the LED chip 20 to pass and reflects the first excitation light. The central wavelength of the LED light may be between 430 nm and 500 nm, for example, the LED light is a blue light having a wavelength of 465 nm. The central wavelength of the first excitation light may be between 570 nm and 610 nm, for example, the first excitation light is a yellow light having a wavelength of 585 nm. In this way, the light emitted by the multi-stack package LED is the white light formed by mixing a blue light and a yellow light.

### THE SIXTH EMBODIMENT

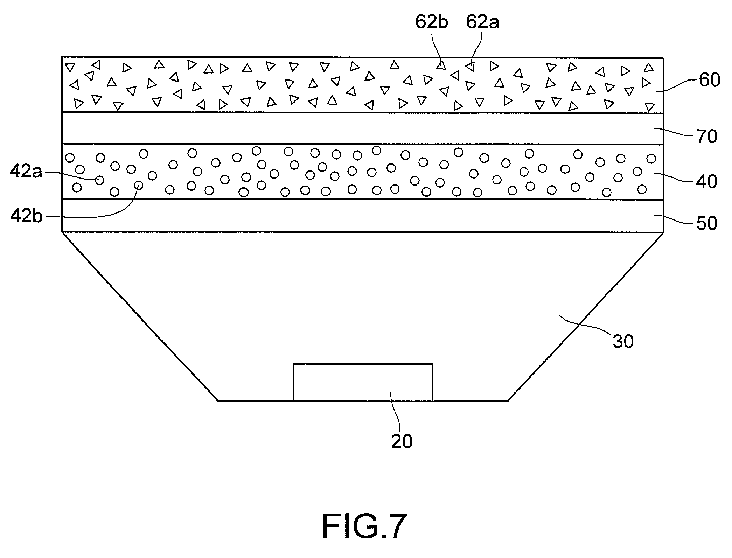

FIG. 7 is a schematic sectional view of a multi-stack package LED according to a sixth embodiment of the present disclosure. Referring to FIG. 7, the multi-stack package LED comprises an LED chip 20, a package 30, a first optical bandpass filter layer 50, a first fluorescent powder layer 40, a second optical bandpass filter layer 70 and a second fluorescent powder layer 60.

The package 30 is covered on the LED chip 20. The first optical bandpass filter layer 50, the first fluorescent powder layer 40, the second optical bandpass filter layer 70 and the second fluorescent powder layer 60 are sequentially stacked on the package 30. In specific, the first optical bandpass filter layer 50 is disposed on the LED chip 20, and the first fluorescent powder layer 40 is disposed on the first optical bandpass filter layer 50. Furthermore, the second optical bandpass filter layer 70 is disposed on the first fluorescent powder layer 40 and the second fluorescent powder layer 60 is disposed on the second optical bandpass filter layer 70.

The first fluorescent powder layer 40 has multiple first fluorescent powders 42a, 42b. The second fluorescent powder layer 60 has multiple second fluorescent powders 62a, 62b. When the first fluorescent powders 42a, 42b are excited, the first excitation light is generated. When the second fluorescent powders 62a, 62b are excited, the second excitation light is generated. The wavelength of the second excitation light is shorter than the wavelength of the first excitation light. The thickness of the first fluorescent powder layer 40 and the second fluorescent powder layer 60 is between 100 µm and 300 µm.

The first optical bandpass filter layer 50 allows the LED light coming from the LED chip 20 to pass and reflects the first excitation light. The second optical bandpass filter layer 70 allows the LED light and the first excitation light to pass and reflects the second excitation light. The central wavelength of the LED light may be between 430 nm and 500 nm, for example, the LED light is a blue light having a wavelength of 465 nm. The central wavelength of the first excitation light may be between 610 nm and 780 nm, for example, the first excitation light is a red light having a wavelength of 650 nm. The central wavelength of the second excitation light may be between 540 nm and 560 nm, for example, the second excitation light is a green light having a wavelength of 550 nm. In this way, the mixed light emitted by the multi-stack package LED is the white light formed by mixing a blue light, a red light and a green light.

### THE SEVENTH EMBODIMENT

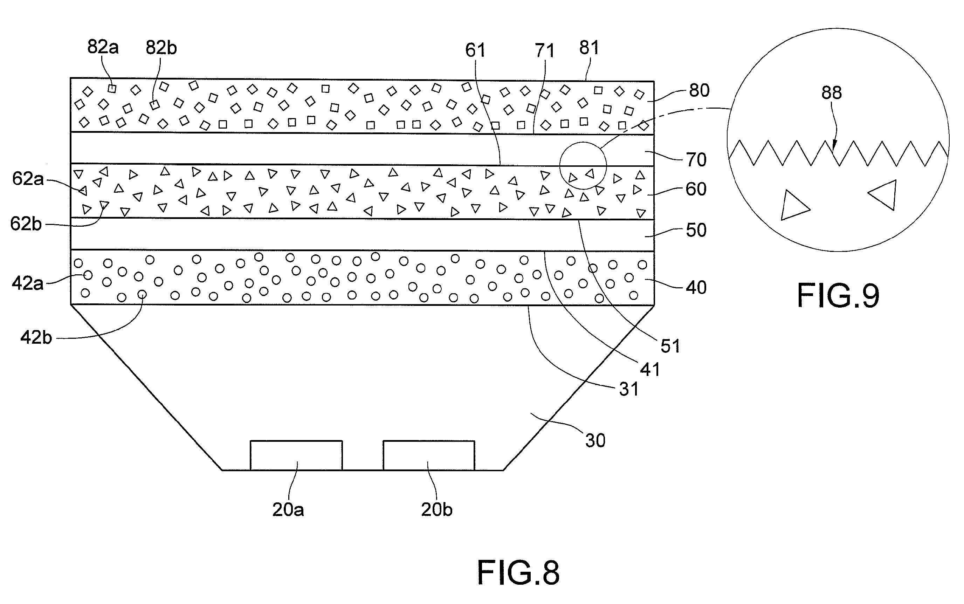

Please refer to FIG. 8 and FIG. 9 simultaneously. FIG. 8 is a schematic sectional view of a multi-stack package LED according to the seventh embodiment of the present disclosure. FIG. 9 is a partially enlarged sectional view of the seventh embodiment of the present disclosure.

Referring to FIG. 8, the multi-stack package LED comprises multiple LED chips 20a, 20b, a package 30, a first fluorescent powder layer 40, a first optical bandpass filter layer 50, a second fluorescent powder layer 60, a second optical bandpass filter layer 70 and a third fluorescent powder layer 80. As shown in FIG. 9, the multi-stack package LED further comprises at least one pattern-structured surface 88. In this embodiment, the pattern-structured surface 88 is disposed on the interface 61 between the second fluorescent powder layer 60 and second optical bandpass filter layer 70. However, the pattern-structured surface 88 can be disposed on one of the interfaces 41, 51, 71 between the adjacent layers (the first fluorescent powder layer 40, the first optical bandpass filter layer 50, the second fluorescent powder layer 60, the second optical bandpass filter layer 70, the third fluorescent powder layer 80), top surface 81 of the third fluorescent powder layer 80, or the bottom surface 31 of the package 30. In addition, the patterned structured surface 88 can be disposed on each of the interface 41, 51, 61, 71, the top surface 81 and the bottom surface 31.

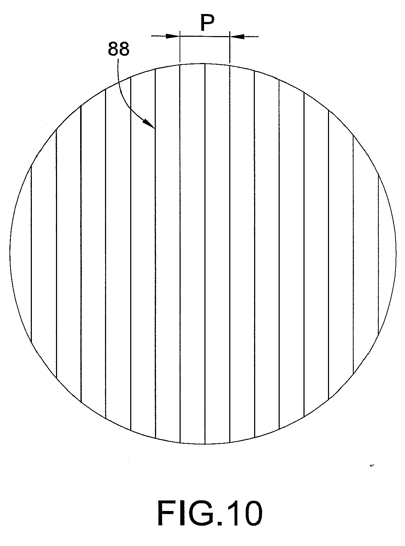

Please refer to FIG. 10 which is the top view of FIG. 9. The pattern-structured surface 88 is structured with zigzag pattern. The pitch P shown on FIG. 10 can be several nanometers to hundreds micrometers so that the amount of the light passing through the pattern-structured surface 88 can be increased. In other words, the multi-stack package LED with the pattern-structured surface 88 has better light emission efficiency. Additionally, the zigzag pattern can be periodic or aperiodic. Further, the pattern on the pattern-structured surface 88 can be concentric circles (from top view), ripple pattern (from sectional view), dot pattern (from top view), crossing lines (from top view) or any pattern mixed thereof.

The aforementioned multi-stack package LEDs according to the first, second, third, fourth, fifth, sixth and seventh embodiments generating the mixed white light are illustrated; however, the present disclosure is not thus limited. The mixed light may be the light of any color. The LED light, the first excitation light, the second excitation light and the third excitation light are not limited to the UV light, the red light, the yellow light, the green light or the blue light, and may also be the light of other colors.

The materials of the first fluorescent powders 42a, 42b and the second fluorescent powders 62a, 62b may be, but are not limited to, the following.

| COLOR OF THE LIGHT | FLUORESCENT POWDER MATERIAL |
|---|---|
| Blue light | (Ba, Sr, Ca)₅(PO₄)₃(Cl, F, Br, OH)_{:} Eu²⁺, Mn²⁺, Sb³⁺ |
| | (Ba, Sr, Ca)MgAl₁₀O₁₇: Eu²⁺, Mn²⁺ |
| | (Ba, Sr, Ca)BPO₅: Eu²⁺, Mn²⁺ |
| Blue-green | Sr₄Al₁₄O₂₅: Eu²⁺ |
| Light | BaAl₈O₁₃: Eu²⁺ |
| Green Light | (Ba, Sr, Ca)MgAl₁₀O₁₇: Eu²⁺, Mn²⁺(BaMn) |
| | (Ba, Sr, Ca)Al₂O₄: Eu²⁺ |
| | (Y, Gd, Lu, Sc, La)BO₃: Ce³⁺, Tb³⁺ |
| | Ca₈Mg(SiO₄)₄Cl₂: Eu²⁺, Mn²⁺ |
| Yellow-orange | (Sr, Ca, Ba, Mg, Zn)₂P₂O₇: Eu²⁺, Mn²⁺ (SPP) |
| Light | (Ca,Sr,Ba,Mg)₁₀(P04)6(F,Cl,Br,OH):Eu²⁺,Mn²⁺(HALO) |
| | (Gd,Y,Lu,La)₂O₃:Eu³⁺,Bi³⁺ |
| | (Gd,Y,Lu,La)₂O₂S:Eu³⁺,Bi³⁺ |
| Red Light | (Gd,Y,Lu,La)VO₄:Eu³⁺,Bi³⁺ |
| | (Ca,Sr)S:Eu²⁺,Ce³⁺ |
| | SrY₂S₄:Eu²⁺,Ce³⁺ |

In summary, the multi-stack structure together with the selection of the wavelengths of the present disclosure can improve the light output efficiency, and further the appropriate configurations of the refraction indexes or optical bandpass filter layers may further avoid the secondary excitation of the fluorescent powder and absorption loss.

## Claims

1. A multi-stack package light emitting diode (LED), comprising:
an LED chip, for generating an LED light when being driven;
a first fluorescent powder layer, disposed on the LED chip and having multiple first fluorescent powders, wherein the first fluorescent powders are excited by the LED light to generate a first excitation light;
a first optical bandpass filter layer, disposed on the first fluorescent powder layer and allowing the LED light and the first excitation light to pass; and
a second fluorescent powder layer, disposed on the first optical bandpass filter layer and having multiple second fluorescent powders, wherein the second fluorescent powders are excited by the LED light to generate a second excitation light, and a wavelength of the second excitation light is shorter than a wavelength of the first excitation light.

2. The multi-stack package LED according to claim 1, wherein the first optical bandpass filter layer reflects the second excitation light, and a wavelength of the LED light is shorter than the wavelength of the second excitation light.

3. The multi-stack package LED according to claim 2, further comprising:
a second optical bandpass filter layer, disposed on the second fluorescent powder layer and allowing the LED light, the first excitation light and the second excitation light to pass; and
a third fluorescent powder layer, disposed on the second optical bandpass filter layer and having multiple third fluorescent powders, wherein the third fluorescent powders are excited by the LED light to generate a third excitation light, and a wavelength of the third excitation light is shorter than the wavelength of the second excitation light.

4. The multi-stack package LED according to claim 3, wherein the second optical bandpass filter layer reflects the third excitation light, and the wavelength of the LED light is shorter than a wavelength of the third excitation light.

5. The multi-stack package LED according to claim 1, further comprising a package clamped between the first fluorescent powder layer and the LED chip, and the package has a slanted side edge, a surface of the package opposite to the LED chip is a light exiting surface, and the slanted side edge reflects the LED light coming from the LED chip to the light exiting surface.

6. The multi-stack package LED according to claim 5, wherein a refraction index of the first fluorescent powder layer is greater than a refraction index of the package.

7. The multi-stack package LED according to claim 1, one of the interface between the first fluorescent powder layer and the first optical bandpass filter layer, the interface between the first optical bandpass filter layer and the second fluorescent powder layer, the top surface of the second fluorescent powder layer, and the bottom surface of the first fluorescent powder layer is a pattern-structured surface.

8. A multi-stack package light emitting diode (LED), comprising:
an LED chip, for generating an LED light when being driven;
a first fluorescent powder layer, having a thickness between 100 µm and 500 µm, disposed on the LED chip and having multiple first fluorescent powders, wherein the first fluorescent powders are excited by the LED light to generate a first excitation light; and
a second fluorescent powder layer, having a thickness between 100 µm and 500 µm, disposed on the first fluorescent powder layer and having multiple second fluorescent powders, wherein the second fluorescent powders are excited by the LED light to generate a second excitation light, a wavelength of the LED light is shorter than a wavelength of the second excitation light, and the wavelength of the second excitation light is shorter than a wavelength of the first excitation light.

9. The multi-stack package LED according to claim 8, wherein a ratio of a refraction index of the first fluorescent powder layer to a refraction index of the second fluorescent powder layer is 1:1.2.

10. The multi-stack package LED according to claim 8, one of the interface between the first fluorescent powder layer and the second fluorescent powder layer, the top surface of the second fluorescent powder layer, and the bottom surface of the first fluorescent powder layer is a pattern-structured surface.

11. A multi-stack package light emitting diode (LED), comprising:
an LED chip, generating an LED light when being driven;
a first optical bandpass filter layer, disposed on the LED chip and allowing the LED light to pass; and
a first fluorescent powder layer, disposed on the first optical bandpass filter layer and having multiple first fluorescent powders, wherein the first fluorescent powders are excited by the LED light to generate a first excitation light, and the first optical bandpass filter layer reflects the first excitation light.

12. The multi-stack package LED according to claim 11, further comprising:
a second optical bandpass filter layer, disposed on the first fluorescent powder layer and allowing the LED light and the first excitation light to pass; and
a second fluorescent powder layer, disposed on the second optical bandpass filter layer and having multiple second fluorescent powders, wherein the second fluorescent powders are excited by the LED light to generate a second excitation light, a wavelength of the second excitation light is shorter than a wavelength of the first excitation light, and the second optical bandpass filter layer reflects the second excitation light.

13. The multi-stack package LED according to claim 11, one of the interface between the first optical bandpass layer and the first fluorescent powder layer, the top surface of the first fluorescent powder layer, and the bottom surface of the first optical bandpass layer is a pattern-structured surface.
